Europäisches Patentamt

European Patent Office

Office européen des brevets

(11) Veröffentlichungsnummer: **0 243 764**
**A2**

(12) **EUROPÄISCHE PATENTANMELDUNG**

(21) Anmeldenummer: **87105357.5**

(22) Anmeldetag: **10.04.87**

(51) Int. Cl.⁴ **B01F 3/04**

(30) Priorität: **24.04.86 DE 3614067**

(43) Veröffentlichungstag der Anmeldung:
**04.11.87 Patentblatt 87/45**

(84) Benannte Vertragsstaaten:
**BE CH DE ES FR GB IT LI LU NL SE**

(71) Anmelder: **SCHERING AKTIENGESELLSCHAFT
Berlin und Bergkamen
Müllerstrasse 170/178 Postfach 65 03 11
D-1000 Berlin 65(DE)**

(72) Erfinder: **Mankut, Ludwig
Memelstrasse 5
D-8503 Altdorf(DE)**
Erfinder: **Kuhn, Peter
Bendiktinerstrasse 47
D-1000 Berlin 28(DE)**

(54) **Einrichtung zum Einleiten von Gasen.**

㊿ Die Erfindung betrifft eine Einrichtung zum Einleiten von Gasen, insbesondere Luft in Flüssigkeiten, die sich in offenen Behältern befinden, dadurch gekennzeichnet. daß diese im wesentlichen besteht aus einem Gehäuse (3) mit einer Gaszutrittöffnung (8) am unteren Gehäuseteil, welches zwei mit Bohrungen versehene. übereinander angeordnete obere Begrenzungswände (4,5) enthält, die das Gehäuse in zwei Kammern (I,2) aufteilen, wobei der Durchmesser der Bohrungen (I9) in der unteren Begrenzungswand wesentlich kleiner ist als der in oberen Begrenzungswand vorgesehenen Bohrungen (20) und die Gesamtfläche der Bohrungen (I9) in der unteren Begrenzungswand kleiner ist als die Querschnittfläche der Gaszuleitsöffnung (8), sowie ein Verfahren unter Verwendung dieser Einrichtung zwecks intensiver Bewegung beziehungsweise Umwälzung von Flüssigkeiten.

Die Erfindung betrifft eine Einrichtung zum Einleiten von Gasen, insbesondere Luft, in Flüssigkeiten, die sich in offenen Behältern befinden gemäß Oberbegriff des Anspruchs I sowie ein Verfahren unter Verwendung dieser Einrichtung gemäß Oberbegriff des Anspruchs I2.

Die Einleitung von Gasen, insbesondere Luft in Flüssigkeiten, die sich in offenen Behältern befinden, zum Beispiel in Galvanisierbäder, ist seit langer Zeit üblich. Wenn auch die Methode nicht bei allen Arten von Galvanisierbädern angewandt werden kann, so hat sie sich doch grundsätzlich sehr bewährt. Mit dem Einleiten von Luft wird bewirkt, daß eine intensive Bewegung des Bades entsteht.

Bisher ist es üblich, die Luft in der Weise in das Bad einzuleiten, daß aus einem unterhalb der Warenstange und parallel zu diesem angeordneten Rohr die Luft austritt. In diesem Einblaserohr sind dazu entlang dessen Längsachse in einer oder mehreren Reihen Bohrungen angebracht. Ferner ist es an eine Versorgungsleitung angeschlossen, über die Luft mit höherem als dem Umgebungsluftdruck zugeführt wird. Der Überdruck muß dabei mindestens so groß sein, daß der Druck der Flüssigkeitssäule über dem Rohr überwunden werden kann.

Die aus dem Einblaserohr austretende Luft steigt in der Flüssigkeit nach oben und führt zu einer Umwälzung des Bades. Da, wie erwähnt, das Einblaserohr im Galvanisierbad unterhalb der Tragstange angeordnet ist, an der die zu galvanisierende Ware hängt, tritt eine Bewegung zwischen dem Bad und dem Galvanisiergut ein. Das hat den erwünschten Effekt, daß ständig frische Badlösung, sogenannter Elektrolyt, über die zu galvanisierende Oberfläche geführt wird.

Bei einem unbewegten Bad tritt dieser Austausch nur sehr langsam ein. Deshalb ändert sich beim Galvanisiervorgang, im unmittelbaren Bereich der Warenoberfläche, die Zusammensetzung des Elektrolyten. Es finden sich in diesem Grenzbereich zum Beispiel weniger Metallionen, weil diese ständig auf dem Galvanisergut abgeschieden werden. Man spricht von einer "Verarmung" des Elektrolyten in diesem Bereich. Die Folge ist, daß der Galvanisierstrom, mit dessen Hilfe das Überzugmetall abgeschieden wird, niedrig gehalten werden muß, damit die abgeschiedene Schicht qualitativ entspricht. Die Anwendbare "Stromdichte" ist also gering. Deshalb dauert es relativ lange bis eine Schicht mit der gewünschten Dicke abgeschieden ist. Es ist natürlich eine möglichst kurze Galvanisierzeit gefordert, um die zur Beschichtung der gegebenen Warenoberfläche erforderliche Anzahl von Galvanisierzellen klein halten zu können. Das Bewegen des Galvanisierbades mit Hilfe von eingeblasener Luft ist ein Mittel, dies zu erreichen.

Bei den bisher bekannten Ausführungen dieser "Lufteinblasung" hat sich jedoch gezeigt, daß es - schwierig ist, für die aus dem Einblasrohr austretende Luft eine gleichmäßige Verteilung zu erreichen.

An die Gleichmäßigkeit der Verteilung werden hohe Ansprüche gestellt, weil davon direkt die Gleichmäßigkeit der abgeschiedenen Metallschicht abhängt. Insbesondere bei elektronischen Bauelementen, wie zum Beispiel Leiterplatten, sind nur sehr kleine Tolerenzen in der Schichtdicke zulässig.

Es gibt nun verschiedene Gründe, die eine gleichmäßige Verteilung der Luft erschweren.

Einmal muß das Rohr beziehungsweise die Reihe der Luft-Austrittsbohrungen absolut horizontal ausgerichtet sein. Ferner muß das Rohr so formsteif sein, daß es sich nicht durchbiegt, wenn die Einrichtung nicht in Betrieb ist, da sonst bei der Inbetriebnahme die in das Rohr eingedrungene Flüssigkeit ungleichmäßig verdrängt wird. Ist das Rohr dagegen mit Luft gefüllt, darf der entstehende Auftrieb ebenfalls nicht zu einer Durchbiegung - nach oben - führen.

Zur Erzielung einer möglichst gleichmäßigen Verteilung der Luft über die gesamte Rohrlänge, ist es üblich, Austrittsbohrungen auf der Unterseite des Rohres anzuordnen. Dadurch wird bei der Inbetriebnahme der Einrichtung zunächst der gesamte Rohrquerschnitt mit Luft aufgefüllt, bevor diese aus den Bohrungen gleichmäßig austritt. Dies wird jedoch nur erreicht, wenn der Rohrquerschnitt, der Durchmesser der Bohrungen und deren Anzahl optimal ausgewählt wurden und diese Parameter zueinander im Einklang stehen. Da jedoch auch andere Forderungen einzuhalten sind, zum Beispiel die, daß die Bohrungen nicht zu klein sein dürfen, weil sonst die Luftblasen zu klein werden und an der Warenoberfläche hängen bleiben, ist es - schwer, eine Lösung in der bisher üblichen Ausführungsform zu finden, die allen Forderungen gerecht wird.

Aufgabe der vorliegenden Erfindung ist die Schaffung einer Einrichtung und eines Verfahrens, welches ohne die Nachteile der Einrichtungen und Verfahren des Standes der Technik eine absolut gleichmäßige Verteilung von Gasen, insbesondere Luft, beim Einleiten in Flüssigkeiten zu erreichen.

Diese Aufgabe wird erfindungsgemäß durch den in den Ansprüchen gekennzeichneten Gegenstand gelöst.

Die erfindungsgemäße Einrichtung ermöglicht in bisher nicht erreichbarer Weise eine absolut gleichmäßige Verteilung von Gasen in Flüssigkeiten und damit eine intensive Bewegung beziehungsweise Umwälzung dieser Flüssigkeiten.

Dies wird erfindungsgemäß dadurch erreicht, indem die beiden Funktionen a) Verteilung des Gases über eine vorgegebene Strecke und b) Kalibrierung der Blasen in zwei Stufen erfolgt. Hierzu werden zwei Kammern verwendet, wobei die Luftaustrittsöffnungen der ersten Kammer einen kleinen Einzelquerschnitt und einen kleinen Gesamtquerschnitt im Verhältnis zur zugeführten Luft besitzen, damit in den Austrittsöffnungen dieser Kammer ein relativ starker Druckabfall eintritt, der zwischen bestimmten Bereichen des Einleitungsdruckes liegt und die Austrittsöffnung der zweiten Kammer, in welche die Luft aus der ersten Kammer geleitet wird, so dimensioniert sind, daß der gewünschte Blasendurchmesser der in den Behandlungsraum austretenden Luft erreicht wird.

Zur Anpassung an unterschiedliche Forderungen sind nach einer weiteren Ausgestaltung der Erfindung, die Begrenzungswände der beiden Kammern, welche die Austrittsöffnungen tragen, auswechselbar.

Die Erfindung ist anhand eines Ausführungsbeispiels näher beschrieben.

Figur I zeigt den Querschnitt einer Lufteinblaseeinrichtung 10, mit der ersten Kammer I und der zweiten Kammer 2. Die Einrichtung besteht aus dem U-förmigen Gehäuse 3, der oberen Begrenzungswand 5 für die zweite Kammer. Für die Zuführung der Luft in die erste Kammer I dient ein Anschlußstutzen 6 mit einer Flanschverbindung 7. Über der Luftzutrittsöffnung 8 ist eine Prallplatte 9 angeordnet, die verhindert, daß die in die Kammer I einströmende Luft sofort auf die Begrenzungswand 4 zuströmt.

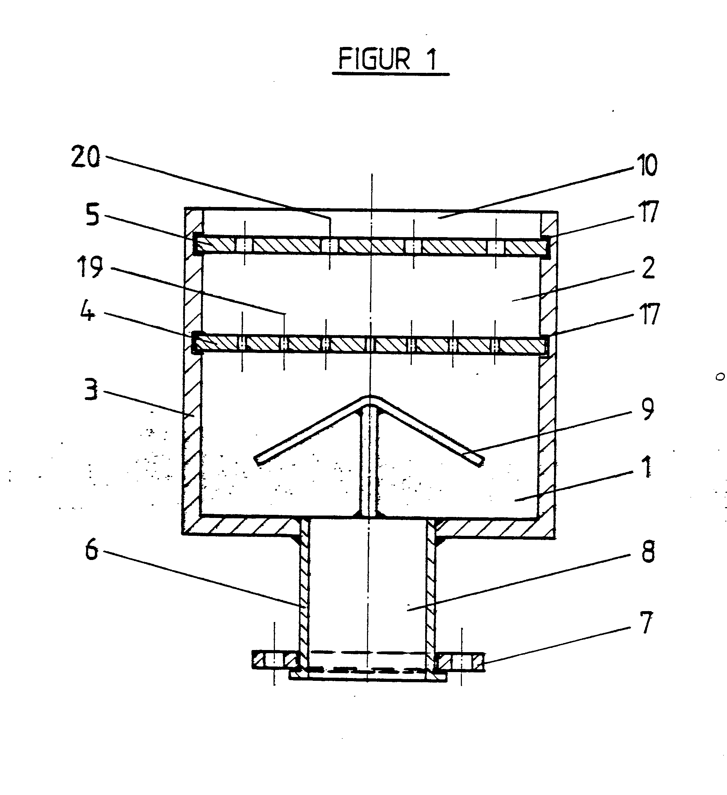

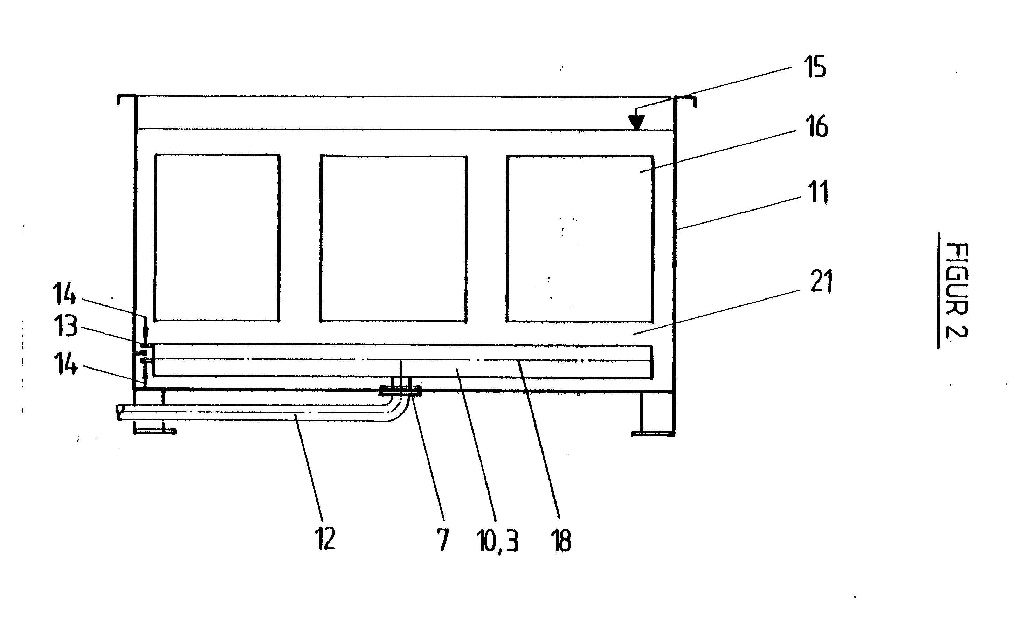

In Figur 2, die einen anderen Maßstab als Figur I hat, ist ein Galvanisierbehälter II im Längsschnitt dargestellt, in den die Lufteinblaseeinrichtung 10 eingebaut ist.

Die Zuführung der Luft auf die Einrichtung 10 erfolgt über die Leitung 12. Über die Flanschverbindung 7 ist die Einrichtung 10 mittig an die Leitung 12 angeschlossen. Das Gehäuse 3 ist an den Enden verschlossen. An einem Ende ist eine Einstellvorrichtung 13 angebracht, die es ermöglicht, die Einrichtung 10 genau horizontal zu justieren, wie es die Pfeile 14 andeuten. Im Behälter II ist ferner der Flüssigkeitsspiegel 15 des Elektrolyts und das zu galvanisierende Gut 16 dargestellt. Andere für den Galvanisierprozess erforderliche Bauteile, wie die Anoden und die Stromzuführungen auf diese und auf das Galvanisiergut 16 sind der Einfachheithalber nicht dargestellt.

Wie in der Figur I gezeigt, sind bei dem beschriebenen Beispiel die Begrenzungswände 4 und 5 in Führungsnuten 17 des Gehäuses 3 eingeschoben. Dazu ist eine Stirnwand des Gehäuses 3 demontierbar (nicht dargestellt). Damit ist es leicht möglich, die Begrenzungswände 4 und 5 gegen andere Ausführungen auszutauschen.

Alle Teile der beschriebenen Ausführung sind aus Kunststoff gefertigt. Durch die Formgebung des Gehäuses 3 sowie die Dimensionierung der Bauteile werden Verformungen der Einrichtung 10 insbesondere in der Längsachse 18 mit Sicherheit vermieden.

Wie in der Zeichnung angedeutet, ist der Durchmesser der Öffnungen 19 in der Begrenzungswand 4 wesentlich kleiner als in der Begrenzungswand 5. Auch ist die Gesamtfläche der Öffnungen in der Wand 4 wesentlich kleiner als die Querschnittsfläche des Anschlußstutzens 6 beziehungsweise des Rohres 12. Dadurch wird die Luft in der Kammer I gestaut und es entsteht ein Druckgefälle zwischen Kammer I und 2.

In der Begrenzungswand 5 hingegen sind die Öffnungen 20 größer ausgeführt. Sie sind so groß ausgeführt, wie es zur Erreichung optimaler Prozeßbedingungen in der Galvanisierzelle 21 erforderlich ist.

Die Gesamtfläche der Öffungen 20 kann so gewählt werden, daß zwischen der Kammer 2 und der Flüssigkeit oberhalb der Wand 5 kein wesentlicher Druckunterschied besteht. Die Kammer 2 ist deshalb teilweise mit Flüssigkeit gefüllt. Die aus den Öffnungen 19 in die Kammer 2 austretende Luft sammelt sich in einer ganz gleichmäßigen Schicht unterhalb der Wand 5 und beim Durchtritt durch die Öffnungen 20 werden Blasen der gewünschten Größe "kalibriert", die dann in der Flüssigkeit, am Galvanisiergut entlang, nach oben steigen.

Die sich, im Moment der Inbetriebnahme der Einrichtung, in der Kammer I befindende Flüssigkeit, wird aus dieser größtenteils verdrängt.

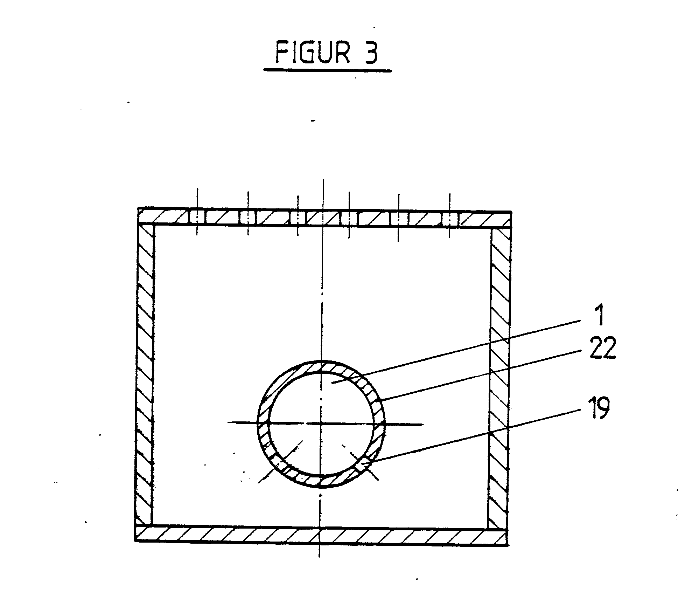

Eine weitere Ausführungsform einer Einrichtung entsprechend der Erfindung zeigt Figur 3. Hier wird die Kammer I durch ein in die Kammer 2 eingeschobenes Rohr 22 gebildet, wobei die Austrittsöffnungen 19 nach unten gerichtet sein können. Die Zuführung der Luft in die Kammer I erfolgt über eine oder beide Stirnseiten des Gehäuses 3.

Die Öffnungen 19 und 20 sind vorzugsweise als Bohrungen mit rundem Querschnitt ausgeführt. Sie können aber auch einen anderen Querschnitt besitzen, zum Beispiel können sie als Schlitze ausgeführt sein.

Die erfindungsgemäße Einrichtung eignet sich zur Bewegung beziehungsweise Umwälzung beliebiger Flüssigkeiten in offenen Behältern, wie beispielsweise Galvanikbädern, die bei der Metallisierung elektronischer Bauelemente vorzugsweise Leiterplatten, angewendet werden.

## Ansprüche

1. Einrichtung zum Einleiten von Gasen, insbesondere Luft in Flüssigkeiten, die sich in offenen Behältern befinden, dadurch gekennzeichnet, daß diese im wesentlichen besteht aus einem Gehäuse (3) mit einer Gaszutrittöffnung (8) am unteren Gehäuseteil, welches zwei mit Bohrungen versehene, übereinander angeordnete obere Begrenzungswände (4,5) enthält, die das Gehäuse in zwei Kammern (1,2) aufteilen, wobei der Durchmesser der Bohrungen (19) in der unteren Begrenzungswand wesentlich kleiner ist als der in oberen Begrenzungswand vorgesehenen Bohrungen (20) und die Gesamtfläche der Bohrungen (19) in der unteren Begrenzungswand kleiner ist als die Querschnittfläche der Gaszuleitsöffnung (8).

2. Einrichtung gemäß Anspruch 1, dadurch gekennzeichnet, daß die Bohrungen (19,20) vorzugsweise einen runden Querschnitt besitzen.

3. Einrichtung gemäß Anspruch 1, dadurch gekennzeichnet, daß die Bohrungen als Schlitze ausgebildet sind.

4. Einrichtung gemäß Anspruch 1, dadurch gekennzeichnet, daß die Begrenzungswände (4,5) und die Stirnwand des Gehäuses (3) austauschbar angewendet sind.

5. Einrichtung gemäß Anspruch 1, dadurch gekennzeichnet, daß das Gehäuse (3) U-förmig ausgebildet ist.

6. Einrichtung gemäß Anspruch 1, dadurch gekennzeichnet, daß diese Teil eines Galvanisierbehälters (11) ist.

7. Einrichtung gemäß Anspruch 1, dadurch gekennzeichnet, daß alle konstruktiven Teile der Einrichtung aus Kunststoff gefertigt sind.

8. Einrichtung gemäß Anspruch 1, dadurch gekennzeichnet, daß durch Stau des Gases in der unteren Kammer (1) ein Druckgefälle zwischen der unteren Kammer und der oberen Kammer (2) besteht.

9. Einrichtung gemäß Anspruch 1, dadurch gekennzeichnet, daß in der unteren Kammer (1) oberhalb der Gaszutrittsöffnug (8) eine Prallplatte (9) angeordnet ist.

10. Einrichtung gemäß Anspruch 1, dadurch gekennzeichnet, daß der Druck zwischen der oberen Kammer (2) und dem äußeren Gehäuseteil gleich ist.

11. Einrichtung gemäß Anspruch 1, dadurch gekennzeichnet, daß anstelle der unteren Kammer (1) ein Rohr (22) vorgesehen ist, das in der oberen Kammer (2) angeordnet ist und nach unten gerichtete Gasaustrittsöffnungen (19) besitzt, wobei sich die Gaszutrittsöffnungen an der Stirnseite des Gehäuses befinden.

12. Verfahren zur Einleiten und gleichmäßigen Verteilung von Gasen, insbesondere Luft in Flüssigkeiten, die sich in offenen Behältern befinden, zwecks Bewegung beziehungsweise Umwälzung dieser Flüssigkeiten, dadurch gekennzeichnet, daß Einrichtungen gemäß Ansprüchen 1 bis 19 verwendet werden.

13. Verfahren gemäß Anspruch 12 zur Bewegung beziehungsweise Umwälzung von Galvanikbädern.

14. Anwendung der Verfahren gemäß Ansprüchen 12 und 13 bei der Metallisierung elektronischer Bauelemente, vorzugsweise Leiterplatten.

FIGUR 1

0 243 764

FIGUR 2

0 243 764

# FIGUR 3

1
22
19